(19) Europäisches Patentamt
European Patent Office
Office européen des brevets

(11) **EP 1 025 592 B1**

(12) **EUROPÄISCHE PATENTSCHRIFT**

(45) Veröffentlichungstag und Bekanntmachung des Hinweises auf die Patenterteilung:
**25.02.2009 Patentblatt 2009/09**

(21) Anmeldenummer: **98961009.2**

(22) Anmeldetag: **14.10.1998**

(51) Int Cl.:
*H01L 29/861* *(2006.01)*

(86) Internationale Anmeldenummer:
**PCT/DE1998/003018**

(87) Internationale Veröffentlichungsnummer:
**WO 1999/021231 (29.04.1999 Gazette 1999/17)**

(54) **HALBLEITERDIODE**

SEMICONDUCTOR DIODE

DIODE A SEMICONDUCTEUR

(84) Benannte Vertragsstaaten:
**CH DE FI FR GB IT LI NL SE**

(30) Priorität: **22.10.1997 DE 19746620**

(43) Veröffentlichungstag der Anmeldung:
**09.08.2000 Patentblatt 2000/32**

(73) Patentinhaber: **Infineon Technologies AG**
**85579 Neubiberg (DE)**

(72) Erfinder: **KELLER, Wolfgang**
**D-81739 München (DE)**

(74) Vertreter: **Müller - Hoffmann & Partner**
**Patentanwälte**
**Innere Wiener Strasse 17**
**81667 München (DE)**

(56) Entgegenhaltungen:
**WO-A-95/22842**     **DE-A- 4 326 846**

- **BYEON D S ET AL: "The breakdown voltage of negative curvatured p+n diodes using a SOI layer" SOLID STATE ELECTRONICS, Bd. 41, Nr. 5, Mai 1997 (1997-05), Seiten 787-788, XP004061934 ISSN: 0038-1101**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft eine Halbleiterdiode mit einer inneren und einer äußeren gekrümmten Elektrode, die eine Kathode und eine Anode bilden, wobei die äußere Elektrode Punktsymmetrie und Ringform aufweist, die innere Elektrode eine Kreisform aufweist, und im Mittelpunkt der äußeren Elektrode angeordnet ist, die äußere Elektrode so stark gekrümmt ist, dass die innere Elektrode komplett von der äußeren Elektrode umgeben ist, die Oberfläche der inneren Elektrode höchstens 20 % des Produkts aus der Breite der inneren Elektrode und der inneren Randlänge der äußeren Elektrode beträgt und die Oberfläche der inneren Elektrode höchstens 20 % der Oberfläche der äußeren Elektrode beträgt.

Dioden sind unsymmetrisch aufgebaute Zweipole, deren Widerstand von der Polarität und der Grösse der angelegten Spannung abhängt. Dioden bestehen aus zwei unterschiedlichen Werkstoffen, von denen wenigstens ein Werkstoff ein Halbleiter ist. Bei den unterschiedlichen Werkstoffen kann es sich um einen Halbleiter und ein Metall oder um einen Halbleiter mit unterschiedlich dotierten Bereichen handeln. Meistens bestehen die unterschiedlich dotierten Bereiche aus p- und n-dotierten Bereichen des gleichen Halbleiters.

Als Dioden sind bekannt: Schaltdioden, Schottkydioden, Gleichrichterdioden, Zenerdioden, Diacs, Fotodioden, Kapazitätsdioden, pin-Dioden, Step-Recovery-Dioden, Tunneldioden, Backward-Dioden.

Es ist bekannt, dass die Kapazität zwischen den Elektroden untereinander sowie zwischen den einzelnen Elektroden und einem Substrat, auf dem diese angeordnet sind, durch zwei verschiedene Phänomene bewirkt wird. Hierbei handelt es sich um die Sperrschichtkapazität und um die Diffusionskapazität.

Die Sperrschichtkapazität kommt dadurch zustande, dass bei einem in Sperrichtung vorgespannten pn-übergang nur ein geringer Sättigungsstrom fliesst. Ausserdem ist eine Raumladung vorhanden. Das bedeutet, dass eine in Sperrichtung gepolte Diode wie ein verlustbehafteter Kondensator wirkt.

Mit zunehmender Sperrspannung verbreitert sich die Sperrschicht. Dies bedeutet wiederum, dass die Ladungsträgerverarmung am pn-Übergang zunimmt. Hieraus folgt, dass die Sperrschichtkapazität Cs mit zunehmender Sperrspannung Ur abnimmt. Bei der Sperrspannung Ur = 0 hat die Sperrschichtkapazität Cs ihren grössten Wert. Für die maximale Sperrschichtkapazität Csmax gilt:

$$C_{smax} = C_s(U_r = 0) = C_{so} = A \cdot \sqrt{\frac{\varepsilon_0 \cdot \varepsilon_r \cdot e}{2|U_d| \cdot \left[\frac{1}{n_A} + \frac{1}{n_D}\right]}}$$

Hierbei ist A die Querschnittsfläche der Sperrschicht und $\varepsilon_r$ die relative Dielektrizitätskonstante. Sie beträgt für Germanium $\varepsilon_r,Ge \approx 16$ und für Silizium $\varepsilon_r,si \approx 20$. Die Abhängigkeit von $C_s$ als Funktion der Sperrspannung $U_r$ ist durch die folgende Beziehung näherungsweise gegeben:

$$C_s = \frac{C_{so}}{\sqrt{1 + \frac{U_r}{U_D}}}$$

Die Diffusionskapazität entspricht einer inneren Trägheit der Diode, die vor allen Dingen durch die Trägheit der Minoritätsladungsträger in den Bahngebieten verursacht wird. Wird die Diode im Durchlass betrieben, so fliessen in den Bahngebieten sowohl Majoritäts- als auch Minoritätsträgerströme. Die Zonen sind zwar in sich elektrisch neutral, aber das Zu- und Abführen der Elektronen bzw. Löcherladungen erfolgt mit getrennten Strömen (Feld- bzw. Diffusionsstrom). Bei kleinen, raschen Veränderungen der Durchlassspannung wirkt dieser Mechanismus aufgrund seiner Trägheit wie eine Kapazität. Sie wird als Diffusionskapazität $C_d$ bezeichnet. Die Diffusionskapazität $C_d$ ist dem Durchlassstrom $I_d$ proportional und beträgt:

$$C_d = \frac{e \cdot A}{2 \cdot U_T \cdot |I_s|} \cdot (L_P + L_N) \cdot \frac{n_A \cdot n_D}{n_A + n_D} \cdot I_d$$

Die Diffusionskapazität spielt bei schnellen Schaltvorgängen, bei denen eine leitende Diode abrupt in den Sperrzustand gebracht wird, eine Rolle. Die gespeicherten Ladungen in den Bahngebieten können dann nur durch Rekombination verschwinden, und die Spannung an der Diode nimmt etwa exponentiell ab.

Aus diesen Gleichungen folgt unmittelbar, dass die gesamte Kapazität zu der Querschnittsfläche der Sperrschicht proportional ist. Aus diesem Grund weisen die bekannten Halbleiterdioden linienförmige Kathodengebiete auf, bei denen die Querschnittsfläche der Sperrschicht minimal ist. Eine darüber hinausgehende Verringerung der Kapazität ist bei den bekannten Dioden nicht möglich. Dies macht sich vor allen Dingen bei ihrer Anwendung mit hochfrequenten Signalen störend bemerkbar.

ESD (Electrostatic Discharge) - Schutzdioden dienen dazu, ein elektronisches Bauteil, beispielsweise einen Feldeffekttransistor, oder eine elektrische Schaltung vor einer irreversiblen Schädigung durch eine elektrostatische Entladung zu schützen, ohne die Funktion zu sehr zu beeinträchtigen. Um diese Schutzfunktion zu erfüllen, wird die Schutzdiode zwischen das zu schützende Bauteil oder die zu schützende Schaltung und ein Erdungspotential geschaltet. Da die Schutzdiode in Sperrrichtung geschaltet ist, fliesst durch sie nur ein kleiner Sperrstrom. Eine möglichst kleine Kapazität der Diode ist erforderlich, um das hochfrequente Signal möglichst wenig zu dämpfen. Die bekannten Dioden sind mit dem Nachteil behaftet, dass ihre Kapazität so hoch ist, dass das Hochfrequenzsignal zu stark gedämpft und verzerrt wird.

Im Einzelnen ist in der DE 43 26 846 A eine Halbleitervorrichtung gemäß des Oberbegriffs des Anspruchs 1 beschrieben, bei der der Abstand zwischen beiden Elektroden auf einen Wert von 100 - 300 $\mu$m festgelegt ist.

Weiterhin zeigt die WO95/22842 eine andere Diode.

Schließlich ist aus BYEON D S ET AL: "The breakdown voltage of negative curvatured p+n diodes using a SOI layer" SOLID STATE ELECTRONICS, Bd. 41, Nr. 5, Mai 1997 (1997-05), Seiten 787-788, XP004061934 ISSN: 0038-1101 eine Diode bekannt, bei der der Abstand zwischen einer Anode und einer Kathode ungefähr 30 $\mu$m beträgt.

Der Erfindung liegt die Aufgabe zugrunde, eine Halbleiterdiode zu schaffen, bei der eine möglichst kleine Kapazität zwischen den Elektroden sowie zwischen den einzelnen Elektroden und dem Substrat vorliegt.

Erfindungsgemäß wird diese Aufgabe bei einer Halbleiterdiode der eingangs genannten Art dadurch gelöst, dass die äußere Elektrode eine Oberfläche von höchstens 15 $\mu$m$^2$ aufweist und ein Abstandsbereich zwischen der inneren Elektrode und der äußeren Elektrode eine Breite zwischen 0,4 $\mu$m und 1,3 $\mu$m hat.

Es ist also vorgesehen, anstelle von geradlinigen Elektroden eine oder mehrere gezielt verformte Elektroden einzusetzen. Diese Verformung erfolgt durch eine Verkrümmung.

Außerdem ist die innere Elektrode so ausgestaltet, dass sie eine gezielt kleinere Fläche als die äußere Elektrode aufweist. Bei der inneren Elektrode kann es sich um die Kathode oder die Anode handeln. Die äußere Elektrode kann dabei durch die Anode oder die Kathode gebildet werden.

Eine besonders zweckmässige Ausführungsform der Erfindung zeichnet sich dadurch aus, dass die Oberfläche der inneren Elektrode höchstens 15% des Produkts aus der Breite der inneren Elektrode und der inneren Randlänge der äußeren Elektrode beträgt.

Besonders zweckmässig ist es, die elektrische Halbleiterdiode so auszugestalten, dass die Oberfläche der inneren Elektrode höchstens 15% der Oberfläche der äußeren Elektrode beträgt.

Eine elektrische Schaltung kann so aufgebaut sein, dass sie eine erfindungsgemäße Halbleiterdiode mit zwei Elektroden, die Kathode und Anode bilden, enthält.

Wenn die äußere Elektrode so stark gekrümmt ist, dass die innere Elektrode wenigstens teilweise von der äußeren Elektrode umgeben ist, wird eine noch weitergehende Verringerung der Kapazität bewirkt.

Eine besonders geringe Kapazität zwischen der äußeren Elektrode und der inneren Elektrode wird dadurch erreicht, dass die äußere Elektrode Punktsymmetrie aufweist.

Eine besonders zweckmäßige Ausführungsform wird dadurch erreicht, dass die äußere Elektrode Ringform aufweist.

Zur weiteren Verringerung der Kapazität zwischen der äußeren Elektrode und der inneren Elektrode ist die innere Elektrode im Mittelpunkt der äußeren Elektrode angeordnet.

Vorteilhafte Weiterbildungen und Besonderheiten der Erfindung ergeben sich aus den Unteransprüchen und der nachfolgenden Darstellung eines bevorzugten Ausführungsbeispiels anhand der Zeichnungen.

Von den Zeichnungen zeigt

Fig. 1 eine Aufsicht auf eine Halbleiterdiode;

Fig. 2 eine Aufsicht auf eine bekannte Halbleiterdiode, und

Fig. 3 eine Aufsicht auf eine Ausführungsform einer erfindungsgemässen Halbleiterdiode.

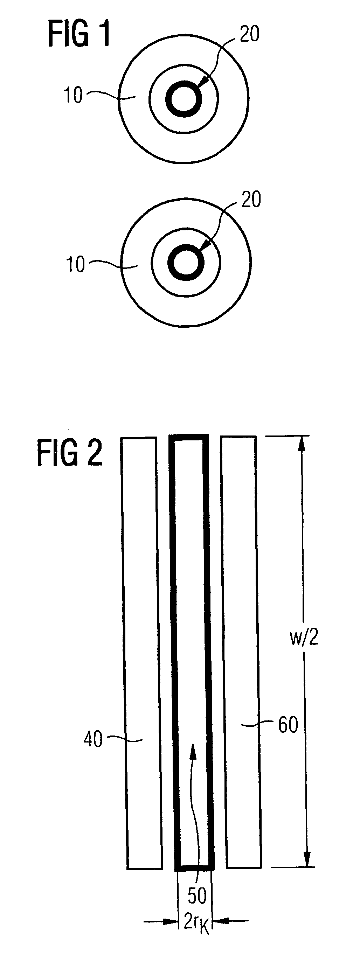

Die beiden in Fig. 1 dargestellten Halbleiterdioden sind auf einer in der Zeichnung nicht dargestellten Strukturebene miteinander in Parallelschaltung verbunden.

Hierbei liegt eine Kathode 20 im Mittelpunkt einer Anode 10. Die Kathode 20 weist einen Durchmesser $d_K = 2\,r_K$ auf, der der minimalen bei dem Herstellungsprozess der Halbleiterdiode möglichen Strukturbreite entspricht. Die Kantenlänge einer einzelnen Kathode beträgt $w_K = 2\,\pi\,r_k$. Die Kathodenfläche einer einzelnen Halbleiterdiode beträgt $A_{Kk} = \pi\,r_k^2$.

Um eine gewünschte Gesamtkantenlänge w zu erzielen, müssen $N_k$ einzelne Bauelemente parallel geschaltet werden. Für die Anzahl $N_k$ der erforderlichen Bauelemente gilt: $N_k = w/w_k$.

Es ergibt sich eine Gesamtkathodenfläche:

$$A_{KG} \;=\; N_k \;\times\; A_{Kk} \;=\; w\;\pi\;r_K^2\,/(2\;\pi\;r_K)\;=\;w\;r_K\,/\,2$$

Die Gesamtkathodenfläche $A_{KG}$ beträgt bei gleicher Gesamtkantenlänge lediglich die Hälfte der Gesamtkathodenfläche $A_{K1}$ der nachfolgend anhand von Fig. 2 dargestellten linearen Struktur.

Durch die dargestellte Anordnung wird auch eine vorteilhafte Abschirmung gegenüber äusseren elektromagnetischen Feldern erzielt. Diese Anordnung hat den zusätzlichen Vorteil, dass gleichzeitig eine besonders geringe und genau definierbare Kapazität erzielt wird.

Die anhand von Fig. 2 dargestellten Halbleiterdioden gehören zum Stand der Technik. Sie weisen eine lineare Struktur auf. Die Gesamtkantenlänge w setzt sich aus den beiden auf die Anoden 40 und 60 gerichteten Kantenlängen w/2 der Kathode 50 zusammen. Die Gesamtkathodenfläche AK1 beträgt:

$$A_{K1} \;=\; 2\;r_K\;\times\;w/2\;=\;w\;\times\;r_D.$$

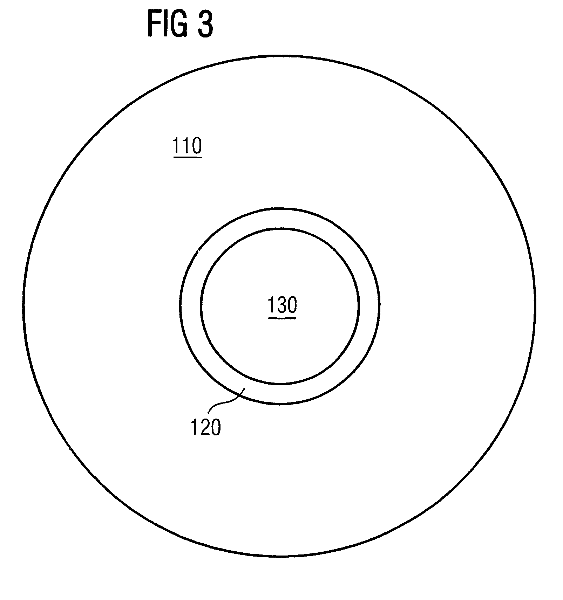

Aus der in Fig. 3 dargestellten Ausführungsform einer erfindungsgemässen Halbleiterdiode wird ersichtlich, dass zwischen der Kathode 130 und der Anode 110 ein schmaler Grenzbereich 120 liegt, dessen Breite vorzugsweise 0,4 $\mu$m bis 1,3 $\mu$m beträgt. Die Breite des Grenzbereichs 120 legt die maximale Stromstärke zwischen der Kathode 130 und der Anode 110 fest.

**Patentansprüche**

1. Halbleiterdiode mit einer inneren und einer äußeren gekrümmten Elektrode (130, 110), die eine Kathode und eine Anode bilden, wobei:

   - die äußere Elektrode (110) Punktsymmetrie und Ringform aufweist,
   - die innere Elektrode (130) eine Kreisform aufweist und im Mittelpunkt der äußeren Elektrode (110) angeordnet ist,
   - die äußere Elektrode (110) so stark gekrümmt ist, dass die innere Elektrode (130) komplett von der äußeren Elektrode (110) umgeben ist,
   - die Oberfläche der inneren Elektrode (130) höchstens 20 % des Produkts aus der Breite der inneren Elektrode (130) und der inneren Randlänge der äußeren Elektrode (110) beträgt und
   - die Oberfläche der inneren Elektrode (130) höchstens 20 % der Oberfläche der äußeren Elektrode (110) beträgt,
   **dadurch gekennzeichnet, dass**
   - die äußere Elektrode (110) eine Oberfläche von höchstens 15 $\mu$m$^2$ aufweist und
   - ein Abstandsbereich (120) zwischen der inneren Elektrode (130) und der äußeren Elektrode (110) eine Breite zwischen 0,4 $\mu$m und 1,3 $\mu$m hat.

2. Halbleiterdiode nach Anspruch 1,
   **dadurch gekennzeichnet, dass**
   die Oberfläche der inneren Elektrode (130) höchstens 15 % des Produkts aus der Breite der inneren Elektrode (130) und der inneren Randlänge der äußeren Elektrode (110) beträgt.

3. Halbleiterdiode nach Anspruch 1 oder 2,
   **dadurch gekennzeichnet, dass**

die Oberfläche der inneren Elektrode (130) höchstens 15 % der Oberfläche der äußeren Elektrode (110) beträgt.

**Claims**

1.  Semiconductor diode having an inner and an outer curved electrode (130, 110), which form a cathode and an anode, wherein:

    - the outer electrode (110) exhibits centrosymmetry and has an annular form,
    - the inner electrode (130) has a circular form and is arranged at the midpoint of the outer electrode (110),
    - the outer electrode (110) is curved to such a great extent that the inner electrode (130) is completely surrounded by the outer electrode (110),
    - the surface area of the inner electrode (130) amounts to at most 20% of the product of the width of the inner electrode (130) and the inner edge length of the outer electrode (110), and
    - the surface area of the inner electrode (130) amounts to at most 20% of the surface area of the outer electrode (110),
    **characterized in that**
    - the outer electrode (110) has a surface area of at most 15 $\mu m^2$, and
    - a spacing region (120) between the inner electrode (130) and the outer electrode (110) has a width of between 0.4 $\mu m$ and 1.3 $\mu m$.

2.  Semiconductor diode according to Claim 1, **characterized in that** the surface area of the inner electrode (130) amounts to at most 15% of the product of the width of the inner electrode (130) and the inner edge length of the outer electrode (110).

3.  Semiconductor diode according to Claim 1 or 2, **characterized in that** the surface area of the inner electrode (130) amounts to at most 15% of the surface area of the outer electrode (110).

**Revendications**

1.  Diode à semi-conducteur ayant une électrode (130) intérieure courbée et une électrode (110) extérieure courbée, qui forment une cathode et une anode, dans laquelle :

    - l'électrode (110) extérieure a une symétrie par rapport à un point et est de forme annulaire,
    - l'électrode (130) intérieure a une forme circulaire et est disposée au centre de l'électrode (110) extérieure,
    - l'électrode (110) extérieure est si courbée que l'électrode (130) intérieure est entourée complètement de l'électrode (110) extérieure,
    - la surface de l'électrode (130) intérieure représente au plus 20 % du produit de la largeur de l'électrode (130) intérieure par la longueur intérieure de bord de l'électrode (110) extérieure et
    - la surface de l'électrode (130) intérieure représente au plus 20 % de l'électrode (110) extérieure,
    **caractérisée en ce que**
    - l'électrode (110) extérieure a une surface de 15 $\mu m^2$ au plus et
    - un intervalle (120) entre l'électrode (130) intérieure et l'électrode (110) extérieure a une largeur comprise entre 0,4 $\mu m$ et 1,3 $\mu m$.

2.  Diode à semi-conducteur suivant la revendication 1, **caractérisée en ce que**
    la surface de l'électrode (130) intérieure représente au plus 15 % du produit de la largeur de l'électrode (130) intérieure par la longueur intérieure de bord de l'électrode (110) extérieure.

3.  Diode à semi-conducteur suivant la revendication 1 ou 2, **caractérisée en ce que**
    la surface de l'électrode (130) intérieure représente au plus 15 % de la surface de l'électrode (110) extérieure.

## FIG 1

## FIG 2

# FIG 3

110

130

120

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4326846 A

- WO 9522842 A

**In der Beschreibung aufgeführte Nicht-Patentliteratur**

- **BYEON D S et al.** The breakdown voltage of negative curvatured p+n diodes using a SOI layer. *SOLID STATE ELECTRONICS,* Mai 1997, vol. 41 (5), ISSN 0038-1101, 787-788